# FASCICULE DE BREVET EUROPEEN

(11) **EP 3 984 339 B1**
(45) Date de publication et mention de la délivrance du brevet: **02.04.2025**
(21) Numéro de dépôt: 20733525.8
(22) Date de dépôt: 08.06.2020
(51) Int. Cl.: H05K 7/14, H05K 9/00, H05K 1/14

(54) **ASSEMBLAGE DE FIXATION ET DE MISE AU POTENTIEL ÉLECTRIQUE DE RÉFÉRENCE POUR CIRCUIT IMPRIMÉ**
ELEKTRISCHE REFERENZPOTENTIALANORDNUNG UND BEFESTIGUNGSANORDNUNG FÜR EINE GEDRUCKTE SCHALTUNG
REFERENCE ELECTRICAL POTENTIAL ASSEMBLY AND ATTACHMENT ASSEMBLY FOR PRINTED CIRCUIT

(30) Priorité: 11.06.2019 FR 1906196
(43) Date de publication de la demande: 20.04.2022
(73) Titulaire: LATELEC, 31500 Toulouse (FR)
(72) Inventeur: MOURIERAS, Julien, 31500 Toulouse (FR)
(74) Mandataire: Junca, Eric
(86) Numéro de dépôt international: PCT/EP2020/025267
(87) Numéro de publication internationale: WO 2020/249257

(56) Documents cités:
- CN-A- 102 781 151
- US-A- 4 458 296
- US-A- 5 381 314
- US-A1- 2010 243 312
- US-A1- 2010 259 907

## Description

### DOMAINE TECHNIQUE

L'invention a trait au domaine de la connectique électrique utilisée notamment dans l'aéronautique pour les baies avioniques d'aéronefs.

Les baies avioniques sont des armoires électriques embarquées dans un aéronef, qui permettent de loger des équipements électriques ou électroniques, tels que des calculateurs ou autres instruments, ainsi que les câblages électriques raccordant ces équipements. Ces baies avioniques sont généralement de taille conséquente et contiennent de nombreux équipements électroniques ou électriques proches les uns des autres, ainsi qu'une grande quantité de câbles. Une baie avionique comporte généralement un dispositif de racks permettant l'insertion et le retrait des équipements, en assurant leur support mécanique et leur connexion électrique. Ces dispositifs de racks garantissent un haut niveau de sécurité dans la gestion des équipements électriques, aussi bien en fonctionnement normal que durant les phases de maintenance.

### ART ANTÉRIEUR

Les baies avioniques d'aéronef comportent généralement des étagères permettant le support des équipements électriques ou électroniques.

Chaque équipement électrique ou électronique a besoin d'être raccordé au potentiel électrique de référence en étant relié à des parties conductrices de masse de la baie avionique.

L'assemblage des circuits électriques et électroniques sur une structure électriquement conductrice comporte généralement un maintien mécanique du circuit mis en œuvre par une fixation de type vis, rondelle, entretoise, et écrou. Par ailleurs, la connexion électrique au potentiel de référence est généralement mise en œuvre par une connexion filaire équipée de deux cosses de raccordement. De tels assemblages sont illustrés dans les brevets CN102781151B, US2010/259907 et US5381314A.

Ce type d'assemblage n'est pas compatible avec un assemblage amené à subir des déformations au cours de son utilisation. Toute déformation amène des contraintes internes dans le circuit ainsi maintenu.

Ce type d'assemblage fait de plus appel à de nombreux composants de petite taille, ce qui est défavorable pour les opérations de maintenance.

La connexion électrique au potentiel de référence nécessite de plus une protection anticorrosion telle qu'un vernis, pour protéger la surface de contact électrique contre les agressions induites notamment par l'environnement d'un aéronef.

### EXPOSÉ DE L'INVENTION

L'invention a pour but d'améliorer les assemblages électriques de l'art antérieur.

A cet effet, l'invention vise un assemblage de fixation et de mise au potentiel électrique de référence pour circuit électrique, cet assemblage comportant une agrafe flexible électriquement conductrice qui comprend :
- une pince conductrice de serrage de circuit électrique ;
- un talon de contact électrique ;
- une fixation adaptée à serrer le talon de contact électrique contre une surface de contact électrique.
L'assemblage comporte en outre une languette électriquement conductrice comportant une patte de fixation sur une structure et présentant une surface de contact électrique, l'agrafe flexible étant fixée sur la languette de sorte que le talon de contact électrique soit disposé contre la surface de contact électrique.

L'assemblage selon l'invention regroupe les deux fonctions de maintien mécanique et de continuité électrique en un seul sous-ensemble solidaire du circuit électrique grâce à la pince. Plusieurs assemblages peuvent être mis en œuvre pour fixer un circuit électrique sur un support tel qu'une étagère de baie avionique, en fonction de la taille du circuit électrique. Ce montage permet d'autoriser au circuit électrique un certain déplacement relatif par exemple à des changements de température, des mouvements mécaniques, ou des vibrations, sans induire de contraintes dans le circuit électrique.

Une intervention sur un système électrique d'aéronef par une opération de dépose-pose de l'assemblage est simplifiée et fiabilisée.

Aucun composé chimique, tel qu'un vernis ou autre protection, n'est nécessaire dans un assemblage selon l'invention.

La baie avionique selon l'invention peut comporter les caractéristiques additionnelles suivantes, seules ou en combinaison :
- la fixation est disposée au centre du talon de contact électrique ;
- l'agrafe flexible comporte des moyens de serrage de la pince sur le circuit électrique ;
- l'agrafe flexible comporte deux mâchoires fixées l'une sur l'autre ;
- le talon de contact électrique est une pièce rapportée sur l'une des mâchoires ;
- le talon de contact électrique et les deux mâchoires sont solidarisés par rivetage ;
- l'agrafe flexible comporte un joint d'étanchéité disposé autour du talon de contact électrique ;
- la languette comporte un écrou fixé sur une face opposée à la surface de contact électrique, cet écrou coopérant avec une vis constituant la fixation de l'agrafe flexible ;
- l'agrafe flexible forme un angle entre sa pince conductrice de serrage et le talon de contact électrique qui est compris entre 90° et 150° ;
- la languette forme un angle entre sa patte de fixation et sa surface de contact électrique qui est qui est compris entre 90° et 150° ;
- l'angle de l'agrafe flexible formé entre sa pince conductrice de serrage et le talon de contact électrique, et l'angle de la languette formé entre sa patte de fixation et sa surface de contact électrique, sont sensiblement égaux ;
- l'agrafe flexible comporte un rebord, et en ce que la languette comporte un rebord, ces deux rebords étant en contact plan sur plan.

### PRÉSENTATION DES FIGURES

D'autres caractéristiques et avantages de l'invention ressortiront de la description non limitative qui suit, en référence aux dessins annexés dans lesquels :
[Fig.1] La figure 1 illustre une baie avionique ;
[Fig.2] La figure 2 représente une étagère de la baie avionique de la figure 1 ;
[Fig.3] La figure 3 représente l'étagère de la figure 2, les connecteurs de module et l'interface de connexion externe étant démontés ;
[Fig.4] La figure 4 représente l'ensemble d'interconnexion de l'étagère de la figure 2 ;
[Fig.5] La figure 5 représente l'étagère de la figure 3 vue de dessous ;
[Fig.6] La figure 6 représente l'étagère de la figure 2 vue en coupe ;
[Fig.7] La figure 7 représente une agrafe de mise au potentiel de référence, de l'étagère de la figure 2 ;
[Fig.8] La figure 8 représente une languette de l'étagère de la figure 2 ;
[Fig.9] La figure 9 représente l'agrafe de la figure 7 vue en coupe ;
[Fig.10] La figure 10 illustre une variante de l'agrafe de la figure 7 ;
[Fig.11] La figure 11 représente l'agrafe de la figure 10 montée sur une étagère.

### DESCRIPTION DÉTAILLÉE

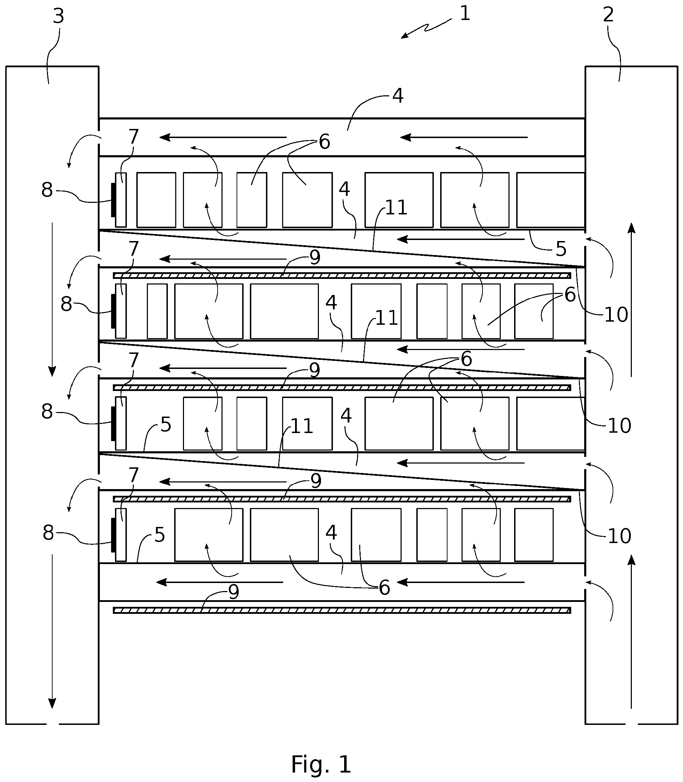

La figure 1 est une représentation schématique d'une baie avionique 1 qui est un environnement particulièrement avantageux pour mettre en œuvre l'assemblage de fixation et de mise au potentiel de référence selon l'invention.

Cette baie avionique 1 comporte deux montants latéraux 2, 3 entre lesquels s'étendent des étagères 4. Chacune des étagères 4 est formée d'un caisson dont la partie creuse s'étend entre une paroi de ventilation 10 et une plateforme de support 5 pour des modules électriques rackables 6 montés sur l'étagère 4.

Les modules électriques 6 sont par exemple des dispositifs électriques, d'électronique de puissance, de calcul relatif aux fonctions de navigation, de sécurité, de climatisation, etc. Ces modules 6 sont dits rackables car ils sont montés sur les étagères 4 de manière amovible, grâce à des chaises de maintien (non représentées sur cette vue schématique de la figure 1) pour faciliter la maintenance et le remplacement de ces modules. Ces modules électriques rackables 6 sont également dénommés LRU (« Line-Replaceable Unit », en anglais). Il s'agit par exemple de modules conformes à la norme aéronautique ARINC.

Chaque étagère 4 comporte, en plus des modules 6, une interface de connexion externe 7 munie de connecteurs d'interface 8. Le circuit électrique de l'aéronef est relié à la baie avionique 1 par l'intermédiaire de ces connecteurs d'interface 8.

L'interface de connexion externe 7 de chaque étagère 4 est reliée à chacun des modules 6 montés sur cette étagère 4 par l'intermédiaire d'un plateau d'interconnexion 9 s'étendant parallèlement à la plateforme de support 5, du côté opposé aux modules 6. Autrement dit, la plateforme de support 5 est située entre les modules 6 et le plateau d'interconnexion 9, pour chaque étagère 4.

Dans le présent exemple, la baie avionique 1 comporte également un dispositif de refroidissement par circulation d'air. Ce dispositif de refroidissement permet de maintenir les équipements électriques et électroniques des modules 6 à une température acceptable compte tenu de leur nombre important, de leur densité, et de la chaleur qu'ils dégagent.

Ce dispositif de refroidissement organise une circulation d'air représentée schématiquement sur la figure 1 par des flèches. Dans le présent exemple, l'air frais est injecté dans la baie avionique 1 par l'un de ses montants 2 puis est distribué dans les étagères 4 formant des caissons canalisant cet air frais pour traverser les modules 6. Différentes portions de chaque étagère 4 sont percées d'orifices de ventilation traversants (non représentés sur cette vue schématique de la figure 1) permettant à l'air de refroidissement de traverser le module 6 pour le refroidir.

L'air réchauffé en traversant les modules 6 est ensuite récupéré dans les étagères 4 qui évacuent l'air chaud vers l'autre montant 3 de la baie avionique 1 pour ensuite être évacué de la baie avionique 1.

Des parois de séparation de flux 11 au sein des caissons formés par les étagères 4 permettent de séparer les flux d'air frais et d'air chaud dans chaque étagère 4 si nécessaire.

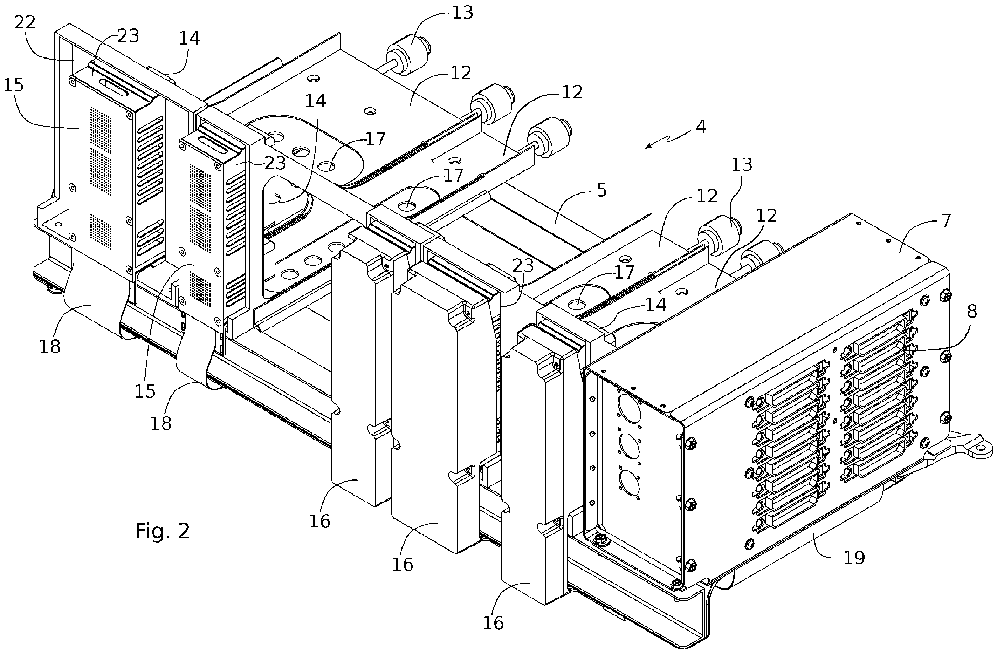

La figure 2 représente l'une des étagères 4 de la baie avionique 1. Sur cette figure 2, les modules 6 n'ont pas été représentés. Seules les chaises de maintien 12 destinées à recevoir ces modules 6 ont été représentées sur la figure 2. Dans le présent exemple, les chaises de maintien 12 sont conformes à la norme ARINC et permettent la fixation mécanique et la connexion électrique de modules 6 compatibles. Le verrouillage mécanique est assuré notamment par des molettes 13 tandis que la connexion électrique des modules 6 est assurée par des connecteurs 14 de module.

Dans l'exemple illustré sur la figure 2, cinq chaises de maintien 12 sont montées sur la plateforme de support 5 de l'étagère 4 permettant donc de recevoir cinq modules électriques rackables, de les fixer par les molettes 13 et de les raccorder électriquement au circuit électrique de l'aéronef grâce aux connecteurs 14 de module. Les molettes 13 sont disposées sur la partie avant des chaises de maintien 12, c'est-à-dire la partie qui est accessible par l'utilisateur quand il est face à la baie avionique.

Comme décrit précédemment, l'étagère 4 comporte également une interface de connexion externe 7 munie de connecteurs d'interface 8 permettant de relier tous les modules de l'étagère 4 au circuit électrique de l'aéronef, pour alimenter électriquement et communiquer avec tous les modules 6 qui sont destinés à être montés dans les chaises de maintien 12. L'interface de connexion externe 7 est également fixée sur la plateforme de support 5.

L'étagère 4 comporte de plus une pluralité de circuits imprimés arrière 15 rigides. Un circuit imprimé arrière 15 est prévu pour chaque connecteur 14 de module. Chacun des circuits imprimés arrière 15 est ainsi disposé en vis-à-vis du connecteur 14 de module d'une chaise de maintien 12. Chaque circuit imprimé arrière 15 et son connecteur 14 de module correspondant sont rigidement fixés l'un à l'autre.

Les circuits imprimés arrière 15 sont chacun protégés par une coque de protection 16. Sur la figure 2, trois des circuits imprimés arrière 15 ont été représentés avec leur coque de protection 16, tandis que deux des circuits imprimés arrière 15 sont montrés dépourvus de leur coque de protection 16 pour rendre visible les circuits imprimés arrière 15.

Les chaises de maintien 12 sont chacune percées d'orifices de ventilation 17 traversant permettant au flux d'air frais issu de l'étagère 4 de traverser le module 6 qui sera monté sur cette chaise de maintien 12.

Chacun des circuits imprimés arrière 15, d'une part, et l'interface de connexion externe 7, d'autre part, sont reliés au plateau d'interconnexion 9 (non visible sur la figure 2) par un circuit imprimé flexible 18, 19. Chaque coque de protection 16 protège avantageusement un circuit imprimé arrière 15 et également son circuit imprimé flexible 18.

Les coques de protection 16 sont de plus munies en leur partie basse de pattes de maintien 61 ou d'ergots dépassants pour assurer le maintien du plateau d'interconnexion 9 une fois installées à l'arrière de chaque circuit imprimé arrière 15. Les coques de protection 16 assurent ainsi une fonction supplémentaire de maintien du plateau d'interconnexion 9.

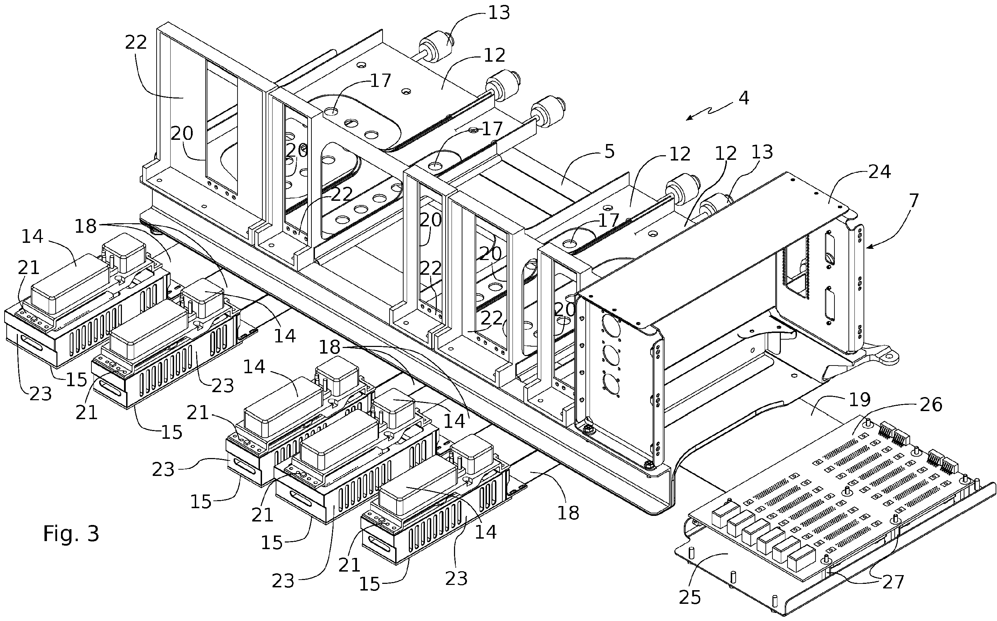

La figure 3 représente l'étagère de la figure 2 avec ses connecteurs 14 de module démontés et avec son interface de connexion externe 7 ouverte.

Chacune des chaises de maintien 12 comporte une paroi de fond 22 s'étendant perpendiculairement à la plateforme de support 5, et dans laquelle est pratiquée une fenêtre de connexion 20. Chaque connecteur 14 de module est monté sur une paroi de connexion 21 qui est fixée (lorsque l'étagère est dans sa position montée de la figure 1) sur les rebords de la fenêtre de connexion 20 de sorte que le connecteur 14 de module est saillant de la fenêtre de connexion 20 pour pouvoir connecter le module reçu dans la chaise de maintien 12. Les parois de connexion 21 et les connecteurs 14 de module s'étendent ainsi chacun perpendiculairement à la plateforme de support 5.

Les connecteurs 14 de module peuvent être de tout type approprié pour assurer la connexion d'un module 6 lorsqu'il est inséré dans la chaise de maintien 12 correspondante jusqu'à venir en butée contre sa paroi de fond 22. Les connecteurs 14 de module peuvent être d'une seule pièce ou au contraire constitués de plusieurs sous-connecteurs. Ces connecteurs 14 de module sont munis de broches s'étendant parallèlement à la plateforme de support 5, en direction du module installé sur la chaise de maintien 12. Ces broches sont des broches d'interconnexion qui sont avantageusement démontables et remplaçables.

Pour chaque chaise de maintien 12, la paroi de connexion 21 est solidaire du circuit imprimé arrière 15 grâce à une entretoise 23. L'entretoise 23 est ici constituée d'une paroi de rebord s'étendant perpendiculairement au circuit imprimé arrière et disposée sur le pourtour du circuit imprimé arrière. La paroi de connexion 21 est fixée d'un côté de l'entretoise 23 et le circuit imprimé arrière 15 est fixé de l'autre côté de l'entretoise 23, le circuit imprimé étant ainsi parallèle à la paroi de connexion 21. La paroi de connexion 21 peut avantageusement être fixée sur la paroi de fond 22 par des fixations vissées dans l'entretoise 23.

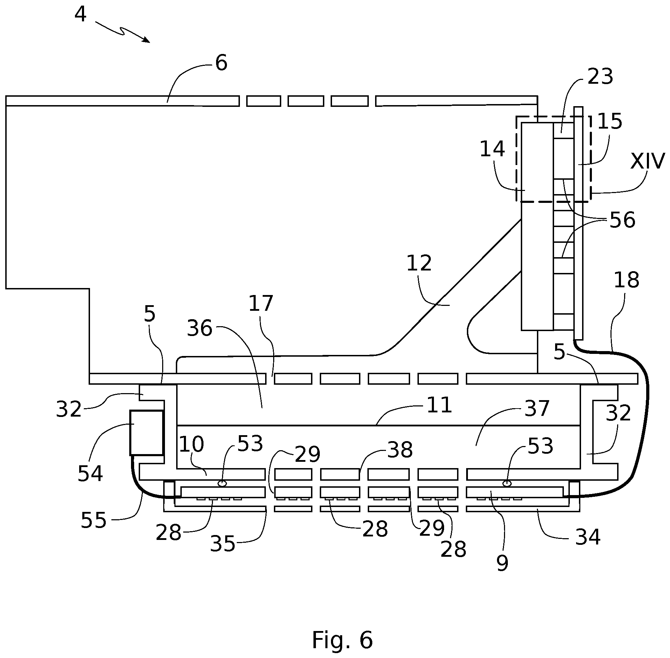

Les broches du connecteur 14 de module sont reliées au circuit imprimé arrière 15 correspondant par tout moyen de câblage tel que par liaison de conducteurs soudés, ou plus avantageusement par des technologies d'enfichage en force de type « press-fit » (en anglais). Les broches de chaque connecteur 14 de module sont ainsi démontables et prolongées par des tiges conductrices rigides qui sont serties dans le circuit imprimé arrière 15 correspondant. Ces tiges conductrices rigides sont couramment dénommées « tulipes ». La réalisation du montage et du raccordement des connecteurs 14 de module est ainsi rapide et sure. Les tiges conductrices 56 sont représentées à la figure 6.

La fixation rigide assurée par l'entretoise 23 permet ici l'emploi de connexions rigides entre le connecteur 14 de module et le circuit imprimé arrière 15 et garantit la longévité de ces connexions dans le temps grâce à un montage où les mouvements relatifs du connecteurs 14 de module et du circuit imprimé arrière correspondant 15 ne sont pas permis.

La figure 3 rend visible la possibilité de mouvement des connecteurs 14 de module lorsqu'ils ont été démontés de leur fenêtre de connexion 20. Ce mouvement est permis par la souplesse des circuits imprimés flexibles 18. La fixation, pour chaque module, de la paroi de connexion 21 sur la fenêtre de connexion 20 se fait de préférence par des vis accessibles depuis l'intérieur de la chaise de maintien 12, c'est-à-dire depuis la face avant (du côté des molettes 13) de l'étagère. Un opérateur peut ainsi facilement accéder à un connecteur 14 de module, en extrayant le module d'une chaise de maintien 12, en dévissant ces vis, et en positionnant le connecteur 14 dans sa position de la figure 3 grâce à la flexibilité du circuit imprimé flexible 18.

En ce qui concerne l'interface de connexion externe 7, celle-ci est constituée d'un boitier de connexion 24 comportant une paroi de connexion externe 25 (qui est montrée démontée sur la figure 3). Un circuit imprimé de connexion externe 26 est fixé parallèlement à la paroi de connexion externe 25 grâce à des entretoises 27 et est relié au circuit imprimé flexible 19.

Les connecteurs d'interface 8 (visibles à la figure 2) sont raccordés au circuit imprimé de connexion externe 26 de manière similaire au connecteur 14 de module. Les connecteurs d'interface 8 comportent ainsi des broches (non représentées pour simplifier les figures) reliées par toute technique appropriée aux pistes du circuit imprimé de connexion externe 26, et notamment par technologie d'enfichage en force permise par le maintien rigide du circuit imprimé de connexion externe 26 par rapport à la paroi de connexion externe 25. Les broches de chaque connecteur d'interface 8 sont ainsi prolongées par des tiges conductrices rigides qui sont serties dans le circuit imprimé de connexion externe 26. Les broches des connecteurs d'interface 8 et ces tiges conductrices rigides peuvent être montées de la même manière que les broches et les tiges des connecteurs 14 de module.

L'interface de connexion externe 7 fournit ainsi, au niveau des connecteurs d'interface 8, la connectique permettant de raccorder toutes les broches des connecteurs 14 de module au circuit électrique de l'aéronef. Le boitier de connexion 24 permet par ailleurs de loger des équipements supplémentaires tels que, fusibles, connecteurs ou afficheurs destinés à la maintenance, ces équipements supplémentaires pouvant être directement montés sur le circuit imprimé de connexion externe 26.

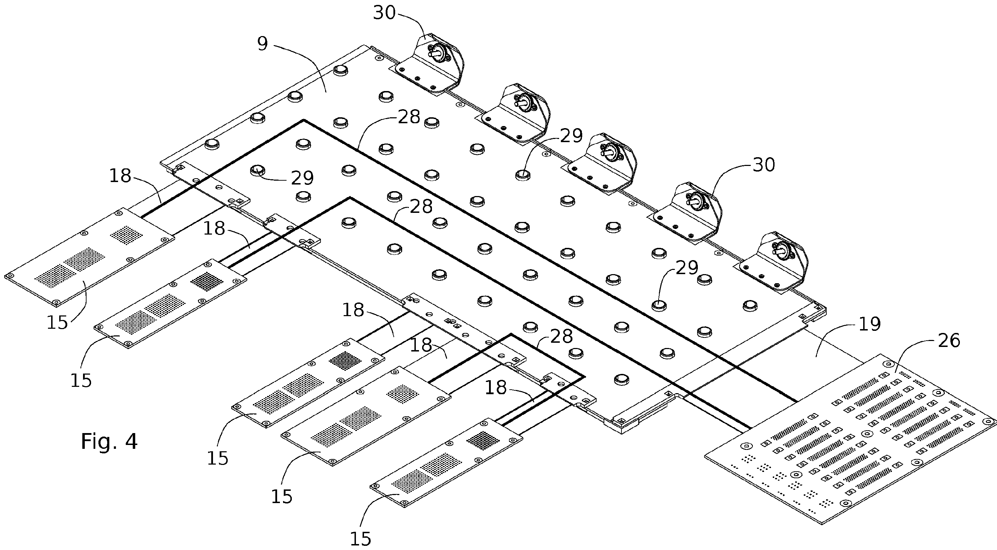

La figure 4 illustre la réalisation de la liaison électrique entre les connecteurs 14 de module et les connecteurs d'interface 8. Cette figure 4 représente un ensemble d'interconnexion dont les circuits imprimés flexibles 18, 19 et rigides 15, 26 ont été représentés, dans une position à plat illustrant une position préférée pour la fabrication de cet ensemble d'interconnexion.

Les circuits imprimés arrière 15 et le circuit imprimé de connexion externe 26 sont chacun reliés au plateau d'interconnexion 9 grâce à leur circuit imprimé flexible 18, 19 respectifs. Dans le présent exemple, le plateau d'interconnexion 9 est un circuit imprimé portant des pistes conductrices de liaison 28 reliant les circuits imprimés flexibles 18 aux circuits imprimés flexibles 19 et éventuellement certains circuits imprimés flexibles 18 entre eux. Les pistes conductrices de liaisons 28 s'étendent, en continu ou avec d'éventuelles interconnexions, des circuits imprimés arrière 15 au circuit imprimé de connexion externe 26.

Sur la figure 4, seules quelques pistes conductrices de liaison 28 ont été schématisées, étant entendu qu'un nombre important de modules 6 peut être monté sur une étagère 4 ce qui génère une grande quantité de connexions électriques de faible et forte puissance à assurer entre les connecteurs 14 de module et les connecteurs d'interface 8 ou entre deux connecteurs 14. La surface du plateau d'interconnexion 9 n'étant limitée que par la surface de l'étagère 4 elle-même, cette surface du plateau d'interconnexion 9 peut être adaptée à ces nombreuses pistes conductrices 28 à supporter. Le plateau d'interconnexion 9 peut de plus être constitué par un circuit imprimé à plusieurs couches si le nombre de pistes conductrices 28 l'exige.

Chaque broche d'un connecteur 14 de module peut ainsi être reliée à une broche d'un connecteur d'interface 8 par un circuit passant par le circuit imprimé arrière 15, le circuit imprimé flexible 18, le plateau d'interconnexion 9, au circuit imprimé flexible 19, et au circuit imprimé de connexion externe 26.

Le plateau d'interconnexion 9 comporte par ailleurs une pluralité d'orifices de ventilation 29 traversant destinés à participer à la fonction de refroidissement de la baie avionique.

Le plateau d'interconnexion 9 comporte de plus des agrafes 30 de mise au potentiel de référence permettant à la fois le maintien mécanique du plateau d'interconnexion 9 par rapport à l'étagère 4 correspondante et la liaison électrique de la masse du plateau d'interconnexion 9 avec la structure métallique de l'étagère 4. Les modules 6 et l'interface de connexion externe 7 peuvent ainsi être mis à la masse de la baie avionique 1 de manière fiable par des pistes conductrices du plateau d'interconnexion 9.

Selon une caractéristique préférée, le plateau d'interconnexion 9, les circuits imprimés arrière 15, le circuit imprimé de connexion externe 26 ainsi que les circuits imprimés flexibles 18, 19 sont fabriqués d'une seule pièce. L'ensemble d'interconnexion représenté à la figure 4 (à l'exception des agrafes 30) est ainsi constitué par un unique circuit imprimé qui comporte des portions rigides 15, 9, 26, et des portions flexibles 18, 19. Cependant, le plateau d'interconnexion 9 peut être également constitué circuit imprimé flexible.

Une fabrication extrêmement rapide et fiable est ainsi permise pour le système d'interconnexion complet de la figure 4.

En variante, si des propriétés de modularité sont préférées pour l'ensemble d'interconnexion, les circuits imprimés flexibles 18 reliés aux circuits imprimés arrière 15 peuvent être connectés au plateau d'interconnexion 9 par l'intermédiaire de connecteurs détachables ce qui permet d'enlever ou d'ajouter des circuits imprimés arrière 15, et donc des connecteurs 14 de module, à un même plateau d'interconnexion 9.

De même, le circuit imprimé flexible 19 du circuit imprimé de connexion externe 26 peut être soit réalisé d'une seule pièce avec le plateau d'interconnexion 9 ou, en variante, connecté par des connecteurs détachables permettant de changer le circuit imprimé de connexion externe 26 pour le remplacer s'il est défectueux, ou pour avoir le choix de connecter différentes interfaces de connexion externes 7 sur un même plateau d'interconnexion 9.

Les circuits imprimés flexibles 18, 19 permettent ici de relier des éléments perpendiculaires entre eux. Une faible contrainte de courbure est donc imposée à ces circuits imprimés flexibles 18, 19, ce qui est un gage de fiabilité.

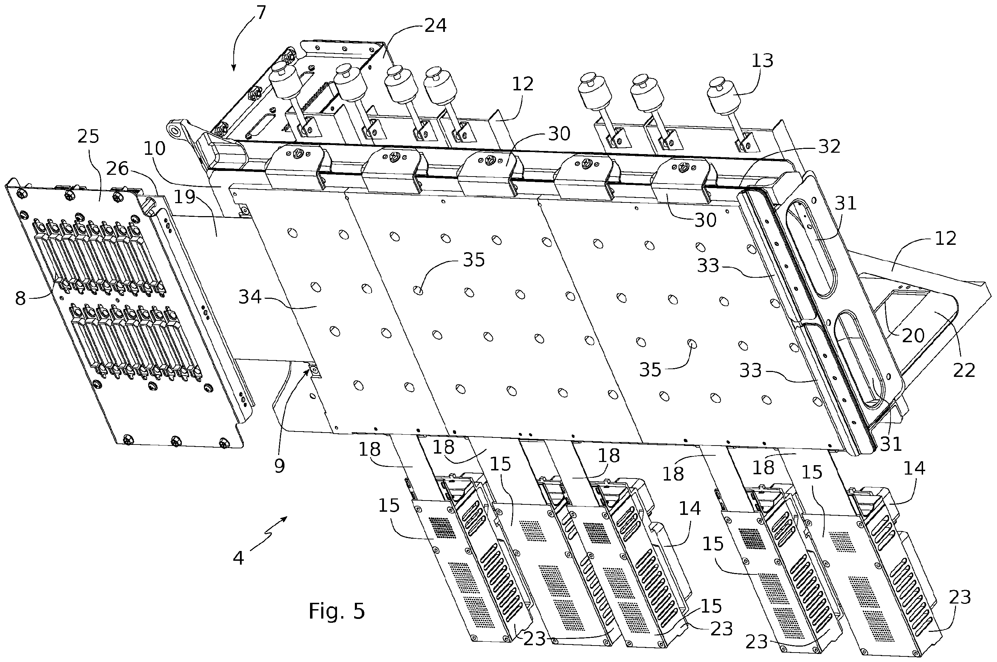

La figure 5 représente l'étagère 4 de la figure 3, vue de dessous. La figure 5 illustre un premier mode de réalisation de l'assemblage du plateau d'interconnexion 9 avec l'étagère 4.

Dans cet exemple, l'étagère 4 forme un caisson à l'intérieur duquel circule l'air de refroidissement qui entre et sort du caisson par des bouches d'aération 31. La plateforme de support 5 délimite la partie supérieure de ce caisson tandis que la paroi de ventilation 10 délimite la partie inférieure de ce caisson, des profilés latéraux 32 délimitant de plus les bords latéraux du caisson.

Le plateau d'interconnexion 9 est fixé en vis-à-vis de la paroi de ventilation 10 grâce aux agrafes 30 de mise au potentiel de référence qui sont fixées sur l'un des profilés latéraux 32 ainsi que par des agrafes complémentaires 33 dont la fonction est uniquement de pincer le plateau d'interconnexion 9 et de le fixer sur la paroi de ventilation 10. De plus, comme décrit précédemment, les coques de protection 16 comportent des pattes de maintien 61 du plateau d'interconnexion 9 et participent ainsi également au maintien optimal du plateau d'interconnexion 9.

Sur la figure 5, le plateau d'interconnexion 9 est muni d'un capot de protection 34 recouvrant quasiment toute sa superficie pour assurer sa protection physique et son isolation électrique. Le capot de protection 34 est de plus muni lui-même d'orifices de ventilation 35 traversant disposés en vis-à-vis des orifices de ventilation 29 du plateau d'interconnexion 9.

La figure 6 est une vue schématique en coupe transversale montrant l'agencement relatif à ce premier mode de réalisation. Sur cette figure 6, un module 6, représenté en coupe, est monté sur une chaise de maintien. Le caisson délimité par l'étagère 4 comporte un conduit d'entrée 36 et un conduit de sortie 37 qui sont séparés par la paroi de séparation de flux 11.

Dans le présent exemple, la plateforme de support 5 est constituée de deux rebords horizontaux des profilés latéraux 32 formant deux traverses planes parallèles sur lesquelles s'appuient les chaises de maintien. La partie supérieure du conduit d'entrée 36 est close par les chaises de maintien et le calibrage de la section de passage de l'air de refroidissement distribué au module 6 est réalisé par le diamètre et le nombre des orifices de ventilation 17 des chaises de maintien.

Comme évoqué précédemment en relation à la figure 1, le conduit d'entrée 36 distribue l'air frais au module 6 par l'intermédiaire des orifices de ventilation 17 de la chaise de maintien et le conduit de sortie 37 permet l'aspiration de l'air chaud qui a traversé le module 6 qui se trouve sur l'étagère du dessous (non représentée). Selon ce premier mode de réalisation, cet air chaud est aspiré dans le conduit de sortie 37 successivement à travers les orifices de ventilation 35 du capot de protection 34, puis les orifices de ventilation 29 du plateau d'interconnexion 9, puis des orifices de ventilation 38 traversant de la paroi de ventilation 10, ces orifices étant de préférence en vis-à-vis comme représenté sur la figure 6.

En variante de la figure 6, les orifices de ventilation 29 du plateau d'interconnexion 9 sont plus petits que les orifices de ventilation 35, 38 du capot de protection 34 et de la paroi de ventilation 10. Les orifices de ventilation 35, 38 du capot de protection 34 et de la paroi de ventilation 10 sont donc sur-dimensionnés tandis que les orifices de ventilation 29 du plateau d'interconnexion 9 assurent le calibrage de la perméabilité à l'air de l'entrée du conduit de sortie 37. Le calibrage de cette perméabilité à l'air est un élément important du système de refroidissement qui est déterminé lors de la conception de la baie avionique, en fonction de l'agencement des différents éléments permettant la génération et la canalisation de l'air de refroidissement. Le calibrage de cette perméabilité étant réalisé par le plateau d'interconnexion, les étagères (et notamment les parois de ventilation) et les capots de protection 34 peuvent être standardisés.

Le plateau d'interconnexion 9 est directement fixé sur l'étagère 4 (voire sur la paroi de ventilation 10), avec ou sans joint d'étanchéité 53 ou entretoise maintenant un écartement entre cette paroi 10 et le plateau d'interconnexion 9. Dans le présent exemple la fixation du plateau d'interconnexion 9 est assurée par les agrafes 30 de mise au potentiel de référence.

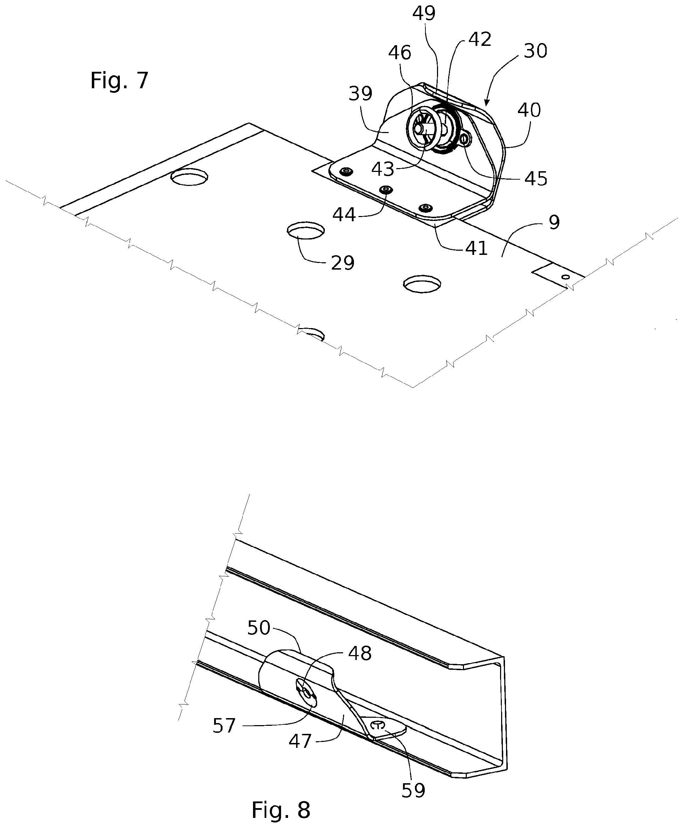

Les figures 7 à 9 illustrent un assemblage de fixation et de mise au potentiel de référence qui comporte l'une des agrafes 30 permettant de relier le plateau d'interconnexion 9 au potentiel électrique de référence et qui permet le maintien mécanique de ce plateau d'interconnexion 9.

L'agrafe 30 est une agrafe flexible formant une pince munie de deux mâchoires 39, 40 serrant entre elles le plateau d'interconnexion 9. Au moins l'une des deux faces du plateau d'interconnexion 9 qui est en contact avec l'agrafe 30 comporte une plage conductrice de masse 41. Les pistes conductrices du plateau d'interconnexion 9 qui doivent être reliées au potentiel électrique de référence de la baie avionique devront être électriquement connectées à cette plage conductrice 41.

L'agrafe 30 est réalisée en un matériau électriquement conducteur de sorte que, lorsque l'agrafe 30 est serrée sur le plateau d'interconnexion 9, la continuité électrique est établie entre la plage conductrice 41 et un talon 42 qui est solidaire de l'une des deux mâchoires 39, 40. Le talon 42 comporte en son centre un orifice permettant le passage d'une vis de fixation 43.

Optionnellement, pour une meilleure longévité et sécurité de connexion, l'agrafe 30 est serrée par des rivets 44 sur le plateau d'interconnexion 9 et les deux mâchoires 39, 40 sont serrées l'une contre l'autre par des rivets 45 de part et d'autre du talon de mise au potentiel 42.

Un joint torique 46 peut par ailleurs être disposé autour du talon de mise au potentiel 42 pour assurer l'étanchéité de la mise au potentiel de référence.

La figure 8 représente en perspective une portion de l'un des profilés latéraux 32 de l'étagère 4, cette portion étant destinée à recevoir la fixation de l'agrafe 30. A cet effet, le profilé latéral 32 comporte une languette 47 électriquement et mécaniquement reliée au profilé latéral 32. Dans cet exemple, la languette 47 comporte une patte de fixation 59 fixée par soudure ou, comme illustré à la figure 8, par rivetage. La languette 47 comporte un écrou serti 48 pour sa coopération avec la vis de fixation 43. La languette 47 comporte, sur sa face opposée à l'écrou serti 48, une surface de contact électrique 57.

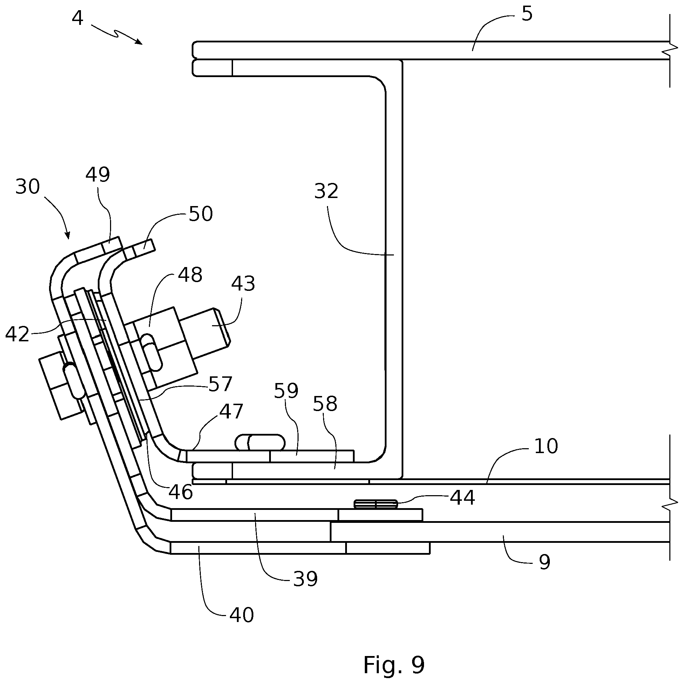

La figure 9 représente en coupe, au niveau de l'agrafe 30, l'assemblage d'un plateau d'interconnexion 9 et d'une étagère 4. La vis de fixation 43 est vissée et serrée sur l'écrou serti 48 de sorte que le joint torique 46 soit comprimé et que le talon de mise au potentiel 42 soit pressé contre la languette 47.

L'agrafe 30 procure ainsi un maintien mécanique du plateau d'interconnexion 9 sans le bloquer en place grâce à la flexibilité de l'agrafe 30 et de la languette 47. Ceci permet d'éviter les contraintes mécaniques au sein du circuit imprimé constituant le plateau d'interconnexion 9, et ce tout en assurant un maintien ferme de ce plateau d'interconnexion 9. Le montage du plateau d'interconnexion 9 et sa mise au potentiel de référence est réalisé par la seule opération de serrage de la vis de fixation 43. Afin de favoriser la mise en place de l'agrafe 30 par rapport à la languette 47, l'agrafe 30 comporte un rebord 49 et la languette 47 comporte un rebord 50 ces deux rebords 49, 50 étant en contact plan sur plan lorsque la vis de fixation 43 est en vis-à-vis de l'écrou serti 48.

En référence à la figure 9, l'agrafe 30 et la languette 47 permettent le montage du plateau d'interconnexion 9 par rapport à une surface qui lui est parallèle (la surface 58 du profilé latéral 32). La languette 47 présente à cet effet un angle entre sa surface de contact électrique 57 et sa patte de fixation 59 qui est supérieur à 90°. De plus, les deux mâchoires 39, 40 de l'agrafe 30 présentent le même angle entre leur portion formant pince et leur portion portant le talon 42. Cet angle est de préférence compris entre 90° et 150°. Le déport créé par cet angle permet l'assemblage visible à la figure 9, cet assemblage procurant un comportement dynamique optimal pour le maintien du circuit électrique constitué du plateau d'interconnexion 9.

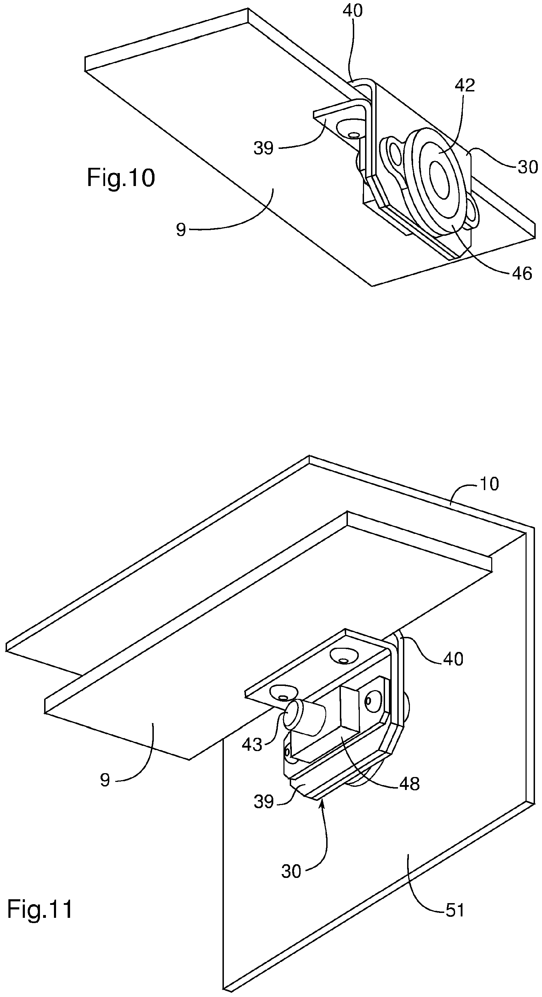

Les figures 10 et 11 illustrent une variante de réalisation de l'agrafe 30 de mise au potentiel de référence. Dans cette variante, la paroi de ventilation 10 comporte un rebord perpendiculaire 51 et le montage du plateau d'interconnexion 9 en vis-à-vis de la paroi de ventilation 10 est réalisé par fixation de l'agrafe 30 sur ce rebord 51. Les deux mâchoires 39, 40 de l'agrafe 30 sont ici constituées de pièces en forme d'équerre adaptées à serrer le plateau d'interconnexion 9 et à le maintenir perpendiculairement au rebord 51 tout en assurant sa mise au potentiel de référence.

Les agrafes 30 suppriment la nécessité de recourir à des tresses, des câbles et des cosses de masse généralement employés en plus des moyens de fixation classiques de circuit imprimé.

Le montage et la connexion sur une étagère 4 d'un tel ensemble d'interconnexion est réalisé par un nombre très restreint d'opérations réduites à la fixation des agrafes 30, 33 sur l'étagère 4, la fixation des parois de connexion 21 sur les chaises de maintien 12, et le montage de l'interface de connexion externe 7. Ces opérations de montage sont d'un nombre très limité comparé aux multiples opérations de câblage nécessaires dans les baies avioniques de l'art antérieur, et ce avec une plus grande sécurité de connexion en limitant les risques d'erreur.

Des variantes de réalisation de la baie avionique décrite peuvent être envisagées sans sortir du cadre de l'invention. Par exemple, le choix d'un plateau d'interconnexion 9 rigide peut conduire à sous-dimensionner l'étagère 4. Il est possible par exemple de diminuer les épaisseurs prévues pour les parois de l'étagère 4, et notamment l'épaisseur de la paroi de ventilation 10 en prenant en compte la rigidité supplémentaire apportée par la fixation du plateau d'interconnexion 9 sur l'étagère 4.

De même, si le choix d'un plateau d'interconnexion 9 en circuit imprimé flexible est réalisé, il est possible de prévoir une étagère 4 souple voire déformable, la souplesse du plateau d'interconnexion 9 accompagnant cette déformation sans induire de contrainte qui pourrait nuire aux pistes conductrices de liaison 28.

Les coques de protection 16 des circuits imprimés arrière 15 et les capots de protection 34 du plateau d'interconnexion peuvent de plus assurer des fonctions de compatibilité électromagnétiques par exemple en isolant électromagnétiquement leur contenu.

L'intégration de composants en face avant de l'étagère 4 est rendue possible par le système d'interconnexion. La figure 6 illustre ainsi un exemple d'intégration d'un équipement 54 en façade d'étagère 4. Cet équipement peut par exemple comporter des afficheurs, des relais, des touches de commande. Cet équipement 54 de façade ne nécessite aucun autre câblage particulier que l'ajout d'un circuit imprimé flexible 55 supplémentaire relié d'une part à cet équipement de façade 54 et d'autre part au plateau d'interconnexion 9.

Par ailleurs, des nappes de câbles peuvent remplacer les circuits imprimés flexibles 18, 19 reliant les circuits imprimés arrière 15 et le circuit imprimé de connexion externe 26 au plateau d'interconnexion 9 .

## Revendications

1. Assemblage de fixation et de mise au potentiel de référence pour circuit électrique comportant une agrafe flexible (30) électriquement conductrice qui comprend :
- une pince conductrice de serrage de circuit électrique ;
- un talon (42) de contact électrique ;
- une fixation (43) adaptée à serrer le talon (42) de contact électrique contre une surface de contact électrique ;
cet assemblage étant **caractérisé en ce qu'**il comporte une languette (47) électriquement conductrice comportant une patte de fixation (59) sur une structure et présentant une surface de contact électrique (57), l'agrafe flexible (30) étant fixée sur la languette (47) de sorte que le talon (42) de contact électrique soit disposé contre la surface de contact électrique (57).

2. Assemblage selon la revendication 1, **caractérisé en ce que** la fixation (43) est disposée au centre du talon (42) de contact électrique.

3. Assemblage selon l'une quelconque des revendications précédentes, **caractérisé en ce que** l'agrafe flexible (30) comporte des moyens (44) de serrage de la pince sur le circuit électrique.

4. Assemblage selon l'une quelconque des revendications précédentes, **caractérisé en ce que** l'agrafe flexible (30) comporte deux mâchoires (39,40) fixées l'une sur l'autre.

5. Assemblage selon la revendication 4, **caractérisé en ce que** le talon (42) de contact électrique est une pièce rapportée sur l'une des mâchoires (39,40).

6. Assemblage selon la revendication 5, **caractérisé en ce que** le talon (42) de contact électrique et les deux mâchoires (39,40) sont solidarisés par rivetage.

7. Assemblage selon l'une quelconque des revendications précédentes, **caractérisé en ce que** l'agrafe flexible (30) comporte un joint d'étanchéité (46) disposé autour du talon (42) de contact électrique.

8. Assemblage selon l'une des revendications précédentes, **caractérisé en ce que** la languette (47) comporte un écrou (48) fixé sur une face opposée à la surface de contact électrique (57), cet écrou (48) coopérant avec une vis (43) constituant la fixation de l'agrafe flexible (30).

9. Assemblage selon l'une des revendications précédentes, **caractérisé en ce que** l'agrafe flexible (30) forme un angle entre sa pince conductrice de serrage et le talon (42) de contact électrique qui est compris entre 90° et 150°.

10. Assemblage selon la revendication 9, **caractérisé en ce que** la languette (47) forme un angle entre sa patte de fixation (59) et sa surface de contact électrique (57) qui est qui est compris entre 90° et 150°.

11. Assemblage selon la revendication 10, **caractérisé en ce que** l'angle de l'agrafe flexible (30) formé entre sa pince conductrice de serrage et le talon (42) de contact électrique, et l'angle de la languette (47) formé entre sa patte de fixation (59) et sa surface de contact électrique (57), sont sensiblement égaux.

12. Assemblage selon l'une des revendications précédentes, **caractérisé en ce que** l'agrafe flexible (30) comporte un rebord (49), et **en ce que** la languette (47) comporte un rebord (50), ces deux rebords (49,50) étant en contact plan sur plan.

## Patentansprüche

1. Anordnung zum Befestigen und zum Anlegen an ein Referenzpotential für eine elektrische Schaltung, umfassend eine elektrisch leitfähige flexible Klammer (30), die Folgendes beinhaltet:
- eine leitfähige Spannklemme für eine elektrische Schaltung;
- eine elektrische Kontaktfahne (42);
- eine Befestigung (43), die dazu angepasst ist, die elektrische Kontaktfahne (42) gegen eine elektrische Kontaktoberfläche zu spannen;
wobei diese Anordnung **dadurch gekennzeichnet ist, dass** sie eine elektrisch leitfähige Zunge (47) umfasst, die eine Lasche zur Befestigung (59) an einer Struktur umfasst und eine elektrische Kontaktoberfläche (57) aufweist, wobei die flexible Klammer (30) so an der Zunge (47) befestigt ist, dass die elektrische Kontaktfahne (42) an der elektrischen Kontaktoberfläche (57) angeordnet ist.

2. Anordnung nach Anspruch 1, **dadurch gekennzeichnet, dass** die Befestigung (43) in der Mitte der elektrischen Kontaktfahne (42) angeordnet ist.

3. Anordnung nach einem der vorhergehenden Ansprüche, **dadurch gekennzeichnet, dass** die flexible Klammer (30) Mittel (44) zum Spannen der Klemme auf die elektrische Schaltung umfasst.

4. Anordnung nach einem der vorhergehenden Ansprüche, **dadurch gekennzeichnet, dass** die flexible Klammer (30) zwei Backen (39, 40) umfasst, die übereinander befestigt sind.

5. Anordnung nach Anspruch 4, **dadurch gekennzeichnet, dass** die elektrische Kontaktfahne (42) ein an einer der Backen (39, 40) angebrachtes Teil ist.

6. Anordnung nach Anspruch 5, **dadurch gekennzeichnet, dass** die elektrische Kontaktfahne (42) und die zwei Backen (39, 40) durch Nieten fest verbunden sind.

7. Anordnung nach einem der vorhergehenden Ansprüche, **dadurch gekennzeichnet, dass** die flexible Klammer (30) eine Dichtung (46) umfasst, die um die elektrische Kontaktfahne (42) herum angeordnet ist.

8. Anordnung nach einem der vorhergehenden Ansprüche, **dadurch gekennzeichnet, dass** die Zunge (47) eine Mutter (48) umfasst, die auf einer zu der elektrischen Kontaktoberfläche (57) entgegengesetzten Seite befestigt ist, wobei diese Mutter (48) mit einer Schraube (43) zusammenwirkt, die die Befestigung der flexiblen Klammer (30) bildet.

9. Anordnung nach einem der vorhergehenden Ansprüche, **dadurch gekennzeichnet, dass** die flexible Klammer (30) zwischen ihrer leitfähigen Spannklemme und der elektrischen Kontaktfahne (42) einen Winkel zwischen 90° und 150° bildet.

10. Anordnung nach Anspruch 9, **dadurch gekennzeichnet, dass** die Zunge (47) zwischen ihrer Befestigungslasche (59) und ihrer elektrischen Kontaktoberfläche (57) einen Winkel zwischen 90° und 150° bildet.

11. Anordnung nach Anspruch 10, **dadurch gekennzeichnet, dass** der Winkel der flexiblen Klammer (30), der zwischen ihrer leitfähigen Spannklemme und der elektrischen Kontaktfahne (42) gebildet ist, und der Winkel der Zunge (47), der zwischen ihrer Befestigungslasche (59) und ihrer elektrischen Kontaktoberfläche (57) gebildet ist, im Wesentlichen gleich sind.

12. Anordnung nach einem der vorhergehenden Ansprüche, **dadurch gekennzeichnet, dass** die flexible Klammer (30) einen Rand (49) umfasst und dass die Zunge (47) einen Rand (50) umfasst, wobei diese zwei Ränder (49, 50) in einem Ebene-Ebene-Kontakt stehen.

## Claims

1. A reference potential setting and fixing assembly for an electrical circuit, comprising an electrically conductive flexible fastener (30) which comprises:
- a conductive clamp for clamping the electrical circuit;
- an electrical contact heel (42);
- a fixing (43) adapted to clamp the electrical contact heel (42) against an electrical contact surface;
this assembly being **characterized in that** it comprises an electrically conductive tongue (47) comprising a fixing tab (59) for fixing to a structure and having an electrical contact surface (57), the flexible fastener (30) being fixed to the tongue (47) such that the electrical contact heel (42) is arranged against the electrical contact surface (57).

2. The assembly as claimed in claim 1, **characterized in that** the fixing (43) is arranged at the center of the electrical contact heel (42).

3. The assembly as claimed in either one of the preceding claims, **characterized in that** the flexible fastener (30) comprises means (44) for clamping the clamp on the electrical circuit.

4. The assembly as claimed in any one of the preceding claims, **characterized in that** the flexible fastener (30) comprises two jaws (39, 40) fixed to one another.

5. The assembly as claimed in claim 4, **characterized in that** the electrical contact heel (42) is a part attached to one of the jaws (39, 40).

6. The assembly as claimed in claim 5, **characterized in that** the electrical contact heel (42) and the two jaws (39, 40) are secured by riveting.

7. The assembly as claimed in any one of the preceding claims, **characterized in that** the flexible fastener (30) comprises a tightness seal (46) arranged around the electrical contact heel (42).

8. The assembly as claimed in one of the preceding claims, **characterized in that** the tongue (47) comprises a nut (48) fixed to a face opposite the electrical contact surface (57), this nut (48) cooperating with a screw (43) constituting the fixing of the flexible fastener (30).

9. The assembly as claimed in one of the preceding claims, **characterized in that** the flexible fastener (30) forms an angle between its conductive clamp and the electrical contact heel (42) which is between 90° and 150°.

10. The assembly as claimed in claim 9, **characterized in that** the tongue (47) forms an angle between its fastening tab (59) and its electrical contact surface (57) which is between 90° and 150°.

11. The assembly as claimed in claim 10, **characterized in that** the angle of the flexible fastener (30) formed between its conductive clamp and the electrical contact heel (42), and the angle of the tongue (47) formed between its fixing tab (59) and its electrical contact surface (57), are substantially equal.

12. The assembly as claimed in one of the preceding claims, **characterized in that** the flexible fastener (30) comprises a flange (49), and **in that** the tongue (47) comprises a flange (50), these two flanges (49, 50) being in flat-on-flat contact.
